# EUROPÄISCHE PATENTSCHRIFT

(11) **EP 0 380 073 B1**
(45) Veröffentlichungstag und Bekanntmachung des Hinweises auf die Patenterteilung: **28.07.1993**
(21) Anmeldenummer: 90101398.7
(22) Anmeldetag: 24.01.1990
(51) Int. Cl.: C03C 17/36, C04B 41/90, B41M 5/24

(54) **Schichtmaterial**
Layered material
Matériau en couche

(30) Priorität: 27.01.1989 CH 275/89
(43) Veröffentlichungstag der Anmeldung: 01.08.1990
(73) Patentinhaber: CIBA-GEIGY AG, 4002 Basel (CH)
(72) Erfinder: Schmidhalter, Beat, Dr., CH-6208 Oberkirch (CH); Spahni, Heinz, CH-4402 Frenkendorf (CH)
(74) Vertreter: Zumstein, Fritz, Dr.

(56) Entgegenhaltungen:
- GB-A- 2 184 746
- US-A- 3 953 625
- US-A- 4 242 438
- JOURNAL OF APPLIED PHYSICS. vol. 42, no. 12, November 1971, NEW YORK US Seiten 4941 - 4944; D.G.MUTH ET AL.: "ANODIC FILMS OF TA-AL ALLOY FILMS."
- CHEMICAL ABSTRACTS, vol. 107, no. 10, 07 September 1987 Columbus, Ohio, USA Seite 303; ref. no. 82664J & JP-A-62123403 (SHARP CORP.) (04-06-1987)
- PATENT ABSTRACTS OF JAPAN vol. 13, no. 9 (P-811)(3357) 11 Januar 1989, & JP-A-63 217522 (YAMAHA CORP.) 09 September 1988,

## Beschreibung

Die Erfindung betrifft ein Schichtmaterial, bei dem sich auf mindestens einer Oberfläche eines Trägers eine dünne transparente und elektrisch leitende Metallschicht eines anodisch oxidierbaren Metalls befindet, die von einer dünnen und transparenten Oxidschicht besagten Metalls bedeckt ist, und worin die Oxidschicht über die Oberfläche verteilt feine, zur Metallschicht geschlossene Poren enthält.

H. Frey et al. beschrieben in Dünnschichttechnologie, Seiten 605-607, VDI-Verlag, Düsseldorf (1987) eine Anzahl von Anwendungsmöglichkeiten für transparente und elektrisch leitende Schichten. Die Forderung nach hoher Transparenz und gleichzeitig hoher elektrischer Leitfähigkeit kann hierbei durch oxidische Halbleiterschichten aus z.B. Indium- und Zinnoxid (ITO-Schichten) erfüllt werden. Es hat sich jedoch als schwierig erwiesen, bei grossflächigeren Beschichtungen die stöchiometrische Zusammensetzung des Mischoxids einzuhalten, die besonders zur Erzielung einer hohen Leitfähigkeit erforderlich ist.

Es ist ferner bekannt, dass Metallschichten aus z.B. Cu, Ag oder Au dann transparent und elektrisch leitend sind, wenn die Schichtdicke um 10 nm oder weniger beträgt. Solche dünnen Schichten sind nur schwer herstellbar, da sich Anordnungen von metallischen Inselstrukturen ausbilden (vgl. J. Appl. Phys. 59(2), S. 571 (1986). S. Kawai et al. beschreiben in J. Electrochem. Soc.: Electrochemical Science and Technology, 122,1, S. 32-34 (1975) die anodische Oxidation von Platten aus Aluminium, bei der eine mikroporöse Al₂O₃-Schicht gebildet wird, die durch eine kompakte Al₂O₃-Schicht vom Aluminiummetall getrennt ist.

In der US-A-4 242 438 wird die vollständige elektrolytische Umwandlung einer sich auf einem dünnen elektrischen Leiter befindenden Aluminiumschicht in eine mikroporöse Al₂O₃-Schicht offenbart.

Es wurde nun gefunden, dass man transparente und elektrisch leitende Metallschichten durch anodische Oxidation herstellen kann, indem die Oxidation gezielt abgebrochen wird.

Ein Gegenstand der Erfindung ist ein Schichtmaterial aus einem Träger, auf dem sich eine elektrisch leitende Metallschicht befindet, die mit einer porösen Metalloxidschicht bedeckt ist, das dadurch gekennzeichnet ist, dass auf mindestens einer Oberfläche des Trägers eine dünne, transparente und elektrisch leitende Metallschicht eines anodisch oxidierbaren Metalls aufgebracht ist, die von einer dünnen und transparenten Oxidschicht des besagten Metalls bedeckt ist, und worin die Oxidschicht über die Oberfläche verteilte feine, zur Metallschicht geschlossene Poren enthält.

Transparent bedeutet eine Lichtdurchlässigkeit von mindestens 10%, bevorzugt mindestens 30% und insbesondere mindestens 60% im sichtbaren Spektralbereich (400-700 nm) z.B. gemessen bei einer Wellenlänge von 500 nm oder im nahen Infrarotbereich, z.B. gemessen bei einer Wellenlänge von 1200 nm an einer Probe mit Glas als Trägermaterial. Die Transparenz wird im wesentlichen durch die Dicke der Metallschicht beeinflusst.

Elektrische Leitfähigkeit bedeutet einen Flächenwiderstand R_{□} der Metallschicht von bevorzugt höchstens 5x10⁴ Ohm, besonders höchstens 5 x 10³ Ohm, und insbesondere höchstens 5 x 10² Ohm.

Der Träger kann opak oder transparent sein. Bevorzugt sind natürliche und synthetische transparente Materialien. Der Träger kann eine beliebige Gestalt besitzen, wobei Folien, Filme und Platten bevorzugt sind. Der Träger kann ein elektrischer Nichtleiter, Halbleiter oder Metalle sein.

Der Träger kann z.B. ein Glas, ein Mineral (Quarz, Saphir, Rubin, Berryl oder Silikate), ein keramisches Material, Silizium oder ein Kunststoff (Cellulose, Polymethacrylate, Polycarbonate, Polyester, Polyolefine, Polystyrol) sein. Bevorzugt besteht der Träger aus Glas oder einem transparenten Mineral oder Kunststoff.

Die Metallschicht kann aus einem Ventilmetall (z.B. Ti oder Ta) oder einer Aluminiumlegierung mit z.B. Mg oder Zn gebildet sein. Insbesondere wird die Metallschicht aus Aluminium selbst gebildet.

Die Dicke der Metallschicht wird nach unten im wesentlichen durch die Perkolationsschwelle bestimmt, bei der der elektrische Widerstand stark ansteigt. Ein bevorzugter unterer Wert für die Schichtdicke ist 1,0 nm. Der obere Wert für die Schichtdicke richtet sich hauptsächlich nach der gewünschten Transparenz. Dieser Wert kann bevorzugt höchstens 50 nm betragen. Bevorzugt beträgt die Dicke 1,0 bis 10 nm und besonders 1,0 bis 5 nm.

Die Dicke der Oxidschicht hängt im wesentlichen von der Ausgangsdicke der Metallschicht ab. Die Oxidschicht kann z.B. 10 nm bis 50 µm besitzen. Zur Vermeidung längerer Elektrolysezeiten ist es vorteilhaft, die Schichtdicke des Metalls vor der Elektrolyse nicht zu hoch zu wählen. Bevorzugte Schichtdickenbereiche sind z.B. 10 nm bis 10 µm und besonders 10 nm bis 100 nm.

Der Durchmesser der Poren in der Metalloxidschicht hängt im wesentlichen von den Herstellungsbedingungen bei der Elektrolyse ab; besonders vom verwendeten Elektrolyten. Der Durchmesser kann z.B. von 2 nm bis 500 nm betragen.

Die Poren sind zur Metallschicht hin geschlossen. Bei der Elekrolyse bildet sich zwischen Metall- und poröser Metalloxidschicht eine dünne, bevorzugt einige nm dicke Barriereschicht aus, die Metall- und poröse Metalloxidschicht voneinander trennt. Die Dicke der Barriereschicht hängt im wesentlichen von der angelegten Spannung ab. Sie kann z.B. 1 bis 100 nm, bevorzugt 5 bis 50 nm betragen.

Ein weiterer Gegenstand ist ein Verfahren zur Herstellung des erfindungsgemässen Schichtmaterials, das dadurch gekennzeichnet ist, dass man einen Träger, der mit einer Schicht eines anodisch oxidierbaren Metalls beschichtet ist, wobei deren Schichtdicke mindestens 5 nm entspricht, in einem Elektrolyten bei einer Spannung von 0,5 bis 100 V anodisch oxidiert, und die Oxidation beendet, bevor die Metallschicht vollständig durchoxidiert ist.

Der mit einem anodisch oxidierbaren Metall beschichtete Träger ist nach bekannten Verfahren erhältlich. So kann z.B. ein Träger mit einer entsprechenden dünnen Metallfolie kaschiert werden, wobei gegebenenfalls die Oberfläche des Trägers zuvor mit einem Klebemittel versehen wird. Vorteilhaft verwendet man Träger, auf die eine dünne Metallschicht durch Sputtern oder chemische Methoden aufgebracht oder mittels der Vakuumtechnik aufgedampft ist. Die Schichtdicke des Metalls wird zweckmässig so gewählt, dass die nach der anodischen Oxidation verbleibende Metallschicht mit einer mindestens 10 nm, vorzugsweise mindestens 100 nm dicken Metalloxidschicht bedeckt ist. Die Schichtdicke des Metalls kann z.B. 10 nm bis 50 µm, bevorzugt 50 nm bis 1 µm und insbesondere 50 nm bis 0,2 µm betragen.

Geeignete Elektrolyte sind bekannt und z.B. in J. Elektrochem. Soc.: Electrochemical Science and Technology, 122,1, S. 32 (1975) beschrieben. Es eignen sich z.B. verdünnte wässrige Lösungen (z.B. bis zu 20 Gew.-%) von anorganischen Säuren oder Carbonsäuren (Schwefelsäure, Phosphorsäure, Chromsäure, Ameisensäure, Oxalsäure), von Alkalimetallsalzen anorganischer Säuren oder Carbonsäuren (Natriumsulfat, Natriumbisulfat, Natriumformiat), und Alkalimetallhydroxide (KOH, NaOH).

Die anodische Oxidation kann bei einer Temperatur von 0 bis 60°C und vorzugsweise bei Raumtemperatur durchgeführt werden. Die zu wählende Spannung hängt im wesentlichen vom verwendeten Elektrolyten ab. Sie kann z.B. 0,5 bis 100 V betragen. Es kann mit Wechselstrom und bevorzugt mit Gleichstrom elektrolysiert werden. Die Stromstärke stellt sich unter den gegebenen Bedingungen nach der gewählten Spannung ein.

Das Verfahren kann z.B. so durchgeführt werden, dass man einen mit einer anodisch oxidierbaren Metallschicht versehenen Träger mit einem elektrischen Leiter verbindet, indem man zunächst den Träger im Endbereich z.B. mit einem Kupferdraht unter Verwendung eines Leitklebers kontaktiert. Man schaltet den Träger als Anode. Als Kathode kann z.B. Graphit verwendet werden. Nach dem Eintauchen des Trägers in den Elektrolyten legt man die gewünschte elektrische Spannung an. Man oxidiert solange, bis die opake Metallschicht sichtbar transparent wird und bricht die Elektrolyse ab, bevor die Metallschicht vollständig oxidiert ist. Dieser Zeitpunkt wird z.B. dadurch ermittelt, das man die elektrische Leitfähigkeit und gegebenenfalls die Transmission im Verlaufe der Elektrolyse mehrfach ermittelt und so den Zeitpunkt bis zur gewünschten Oxidation bestimmt. An Hand solcher Eichkurven kann unter vorgegebenen Reaktionsbedingungen der Zeitpunkt des gezielten Reaktionsabbruches festgelegt werden. Ferner kann auch der Abfall der Stromdichte während der Elektrolyse zur Bestimmung des Zeitpunktes des Reaktionsabbruches verwendet werden. Die Reaktionszeit hängt im wesentlichen von der Dicke der anodisch oxidierbaren Metallschicht und den gewählten Elektrolysebedingungen ab.

Es hat sich als vorteilhaft erwiesen, im Endbereich eine Strombarriere aus einem Nichtleiter aufzubringen, z.B. aus einem härtbaren oder photohärtbaren Kunststoff, um Kapillarwirkungen zu unterbinden und durch zu schnelle Oxidation die Bildung einer isolierenden Oxidschicht zu vermeiden.

Das erfindungsgemässe Schichtmaterial kann z.B. als Elektrode, besonders transparente Elektrode für Displays, als Fensterbeschichtung oder für Solarzellen verwendet werden.

Ein weiterer Gegenstand ist die Verwendung des erfindungsgemässen Schichtmaterials als Informationsaufzeichnungsmaterial besonders durch Markierung mit einem Laser. Hierbei werden mit einem Laserstrahl Markierungen in die Metalloxid- und Metallschicht gebrannt, wobei durch die geringe Wärmeleitfähigkeit und Wärmekapazität der dünnen Metallschicht eine hohe Energieausnutzung möglich ist. Die dadurch erzielte lokale Aenderung der Transmission oder Reflexion kann zum Ablesen von gespeicherten Informationen genutzt werden.

Die magnetischen und optischen Eigenschaften des erfindungsgemässen Materials können nach bekannten Verfahren modifiziert werden. So kann z.B. gemäss dem in der US-A-4 242 438 beschriebenen Verfahren in den Poren der Metalloxidschicht ein Silberhalogenid abgelagert werden, wobei dieses System als Photomaske Verwendung findet.

Es ist ferner möglich, durch sekundäre Elektrolyse in den Poren des Metalloxids Metallkolloide (z.B. Cu, Ag, Au, Pd, Pt oder Rh), organische Materialien wie z.B. Farbstoffe oder Mischungen solcher Stoffe einzulagern. Die erzielte Veränderung der Reflexion und Absorptionseigenschaften ermöglicht die Herstellung von Autoglas oder Architekturglas mit Sonnenschutz- und Wärmedämmeigenschaften. Es können auch Metalle durch stromlose Metallabscheidung in die Poren eingelagert werden. Mit diesen Verfahren können auch dekorative Effekte für die Oberflächengestaltung von Bauteilen erzielt werden.

Erfindsungsgemäss kann nicht nur durch Lasermarkierung, sondern auch durch eine lokal begrenzte Zustandsänderung (z.B. örtliches Schmelzen oder Verdampfen) im erfindungsgemässen Schichtmaterial mit einem Laser Informationen eingeschrieben werden.

A. Bell und F. Spong beschreiben in IEEE J. of Quantum Electronics. Vol. 14, 437-495 (1978), dass in vielen Fällen ein Dreifachschichtsystem bestehend aus Reflektor (transparente Metallschicht), transparenter Abstandsschicht (transparente Metalloxidschicht) und lichtabsorbierender Schicht (z.B. einem Farbstoff) als Aufzeichnungsmaterial besonders vorteilhaft ist.

In diesen Fällen wird durch die optische Schichtdicke von λ/4 (λ = Wellenlänge des eingestrahlten Lichtes) eine besonders hohe Ausnützung (Schwächung) des eingestrahlten Lichtes erreicht.

Die dünne Aluminiumschicht des erfindungsgemässen Schichtmaterials kann nun als leitende Elektrode zum Aufbau eines Dreischichtsystems benutzt werden. Das Aufbringen der Absorbermaterialien wie Gold oder Silber kann durch elektrochemische Reduktion entsprechender Metallsalze in die poröse Oxidmatrix erfolgen. Es wurde überraschenderweise gefunden, dass auch mit Schichtdicken, die deutlich unter λ/4 liegen, sehr empfindliche Aufzeichnungsträger hergestellt werden können. Man erreicht sogar, dass die Schichtdicken der Absorbermetalle sehr genau dimensioniert werden können, z.B. auch zur Einstellung einer Restreflektivität, die für den Fokusservo des Schreib-Lesegerätes benötigt wird.

Das gegebenenfalls modifizierte erfindungsgemässe Schichtmaterial kann auch mit einer Schutzschicht aus bevorzugt transparenten Kunststoffen versehen werden.

Die nachfolgenden Beispiele erläutern die Erfindung näher. Die elektrische Leitfähigkeit bzw. der Flächenwiderstand wird nach der Vierpunktmethode bestimmt.

### A) Herstellungsbeispiele:

Beispiel 1: Auf eine Glasplatte wird im Vakuum eine 100 nm dicke Schicht aus Aluminium aufgedampft. Die Aluminiumschicht wird an der Endfläche mit einem Kupferdraht mittels eines Leitklebers (Leitplatin 308, Firma Demeter, Hanau) kontaktiert und unter der Kontaktstelle mit einem Streifen einer Strombarriere aus einem Photolack (Shipley AZ 111 S) versehen. Diese aufgedampfte Dünnschicht wird dann elektrolytisch umgesetzt, indem die Schicht in einer Schwefelsäurelösung (15 Gew.-%) an die positive Klemme einer Spannungsquelle gelegt wird. Die negative Elektrode besteht aus einer in die Elektrolytlösung gehängten Graphitplatte. Unter Anwendung eines Gleichstroms wird mit einer Stromdichte von 14 mA/cm² bei 23°C während 1 Minute anodisch oxidiert. Auf diese Weise wird die Aluminiumschicht teilweise zu Aluminiumoxid umgesetzt. Die resultierende Schicht hat einen Transmissionsgrad von 68% bei einer Wellenlänge von 500 nm. Der Flächenwiderstand R_{□} der Restaluminiumschicht ist 1,2 k Ω. Die Leitfähigkeiten werden durch Vierpunktmessungen bestimmt, wobei gilt: R_{□} = S/D, S spez. Widerstand in Ω m, D Schichtdicke in m.

Beispiel 2: Die Aluminiumschicht wird nach der Methode des Beispiels 1 2 Sek. länger anodisch oxidiert. Es wird ein Flächenwiderstand von 394 Ω gemessen, bei 70% Transmission im sichtbaren Bereich bis hinauf zu einer Wellenlänge von etwa 1200 nm.

Beispiel 3: In einer Abänderung des Verfahren gemäss Beispiel 1 wird bei diesem Beispiel eine sekundäre Elektrolyse durchgeführt.

Eine 100 nm dicke Aluminiumschicht wird auf ein Glassubstrat aufgedampft und nach der in Beispiel 1 beschriebenen Weise einer primären anodischen Oxidation unterworfen. In diesem Falle wird während 45 Sek. bei 8 Volt Gleichspannung anodisiert.

In einem Folgeschritt wird durch Wechselstrom in einer wässrigen Metallsalzlösung (1,53 g/l AgNO₃, 20 g/l MgSO₄ pH 1,61) während 10 Sek. kolloidales Silber in den Mikroporen des Al₂O₃-Schicht abgeschieden.

Die in dieser Weise erhaltene Schicht besitzt eine goldgelbe Färbung. Es wird ein Flächenwiderstand R_{□} von 401 Ω erzielt und der Transmissionsgrad beträgt 68% bei einer Wellenlänge von 500 nm und 70% bei 700 nm.

Beispiel 4: In diesem Falle wird nach der Methode des Beispiels 3 die anodische Oxidation nach 43 Sek. abgebrochen und in der Oxidschicht gemäss Beispiel 3 Silber abgeschieden. Man erzielt einen Flächenwiderstand R_{□} von 1,8 k Ω und eine Transmission von 45% bei einer Wellenlänge von 500 nm und 48% bei 700 nm. Um die Eigenschaften der so hergestellten Oxidschichten zu bestimmen, wird ein Abschnitt der Probe in eine transparente Epoxygussmasse eingebracht, nach dem Aushärten abgelöst und rechtwinklig zur Probenoberfläche geschnitten (Ultramikrotomie). Dieser Schnitt wird dann unter dem Durchstrahlungselektronenmikroskop analysiert. Es ergibt sich eine Dicke der Metallschicht von etwa 8 nm. Die Oxidschicht ist 140 nm und die Mikroporengrösse ist etwa 10 nm.

### B) Anwendungsbeispiele

Beispiel 5: Eine Glasplatte (Träger) wird durch Aufdampfen mit einer 100 nm dicken Aluminiumschicht bedeckt. Der so beschichtete Träger wird mit einem Elektrodenanschluss kontaktiert und unter Bildung einer anodischen Oxidschicht anodisch oxidiert. Hierzu verwendet man eine Schwefelsäurelösung (15 Gew.-%) und bewirkt die teilweise anodische Oxidation unter Anwendung eines Gleichstroms mit einer konstanten Spannung von 8 V bei 23°C während 65 Sek. Die in dieser Weise erhaltene Oxidschicht hat eine Dicke von etwa 150 nm und eine Mikroporengrösse von etwa 10 nm.
In diese Schicht wird mit Lichtpulsen eines Farbstoff-Lasers (633 nm) mit einer Energie von 1-5 nJ pro Puls und einer Pulslänge von 25 ns eingeschrieben.

Die geschriebenen Marken sind kreisrunde Löcher mit einem Durchmesser von 1,5 µm.

Beispiel 6: Eine Glasplatte von 130 mm Durchmesser wird mit einer Aluminiumschicht von 100 nm Dicke beschichtet. In der gemäss in Beispiel 5 angegebenen Weise wird bei 10V DC während 50 Sekunden anodisiert. In einem Folgeschritt wird aus einem Goldelektrolyten (1g/l HAuCl₄, pH 1.8) bei 8V AC während 30 Sekunden Gold in den Mikroporen abgeschieden. Der erhaltene Aufzeichnungsträger wird mit Licht eines HeNe-Lasers (630 nm) mit einer Intensität von 5 mW bestrahlt, wobei die Strahlung auf einen Brennfleck von 1.0 µm Durchmesser auf der Oberfläche fokussiert ist. Die eingestrahlte Leistung reicht aus, um ein Loch von 1.0 bis 1.2 µm zu erzeugen.
Zur Wiedergabe wird ein auf 10 µW abgeschwächter nicht modulierter Laserstrahl über die beschriebenen Stellen als Aufzeichnungsmedium geführt und das vom Medium reflektierte Licht mit einem Fotodetektor gemessen.
Die Reflexion an einer vorher beschriebenen Stelle unterscheidet sich von einer unbeschriebenen Stelle um 50%.

Beispiel 7: Auf einem Glasträger wird im Vakuum eine Reflektorschicht aus Aluminium von 100 nm aufgesputtert. Entsprechend Beispiel 3 wird bei 10V DC während 60 Sekunden anodisch oxidiert und während 30 Sekunden (8V AC) Silber in die Mikroporen abgeschieden. In diese Schicht wird entsprechend Beispiel 6 mit einem HeNe-Laser ein Punktraster mit gutem Kontrast eingeschrieben.

## Patentansprüche

1. Schichtmaterial aus einem Träger, auf dem sich eine elektrisch leitende Metallschicht befindet, die mit einer porösen Metalloxidschicht bedeckt ist, dadurch gekennzeichnet, dass auf mindestens einer Oberfläche des Trägers eine dünne, transparente und elektrisch leitende Metallschicht eines anodisch oxidierbaren Metalls aufgebracht ist, die von einer dünnen und transparenten Oxidschicht des besagten Metalls bedeckt ist, und worin die Oxidschicht über die Oberfläche verteilte feine, zur Metallschicht geschlossene Poren enthält.

2. Schichtmaterial gemäss Anspruch 1, dadurch gekennzeichnet, dass der Träger aus einem Glas, Mineral, Keramik, Silizium oder Kunststoff besteht.

3. Schichtmaterial gemäss Anspruch 2, dadurch gekennzeichnet, dass der Träger aus Glas oder einem transparenten Mineral oder Kunststoff besteht.

4. Schichtmaterial gemäss Anspruch 1, dadurch gekennzeichnet, dass die Metallschicht aus einem Ventilmetall gebildet ist.

5. Schichtmaterial gemäss Anspruch 4, dadurch gekennzeichnet, dass die Metallschicht aus Aluminium gebildet ist.

6. Schichtmaterial gemäss Anspruch 1, dadurch gekennzeichnet, dass die Metallschicht eine Dicke von 1,0 nm bis 50 nm aufweist.

7. Schichtmaterial gemäss Anspruch 6, dadurch gekennzeichnet, dass die Dicke 1,0 bis 10 nm beträgt.

8. Schichtmaterial gemäss Anspruch 7, dadurch gekennzeichnet, dass die Dicke 1,0 nm bis 5 nm beträgt.

9. Schichtmaterial gemäss Anspruch 1, dadurch gekennzeichnet, dass die Oxidschicht eine Dicke von 10 nm bis 50 µm aufweist.

10. Schichtmaterial gemäss Anspruch 9, dadurch gekennzeichnet, dass die Dicke 10 nm bis 10 µm beträgt.

11. Schichtmaterial gemäss Anspruch 10, dadurch gekennzeichnet, dass die Dicke 10 nm bis 100 nm beträgt.

12. Schichtmaterial gemäss Anspruch 1, dadurch gekennzeichnet, dass die Poren einen Durchmesser von 2 nm bis 500 nm aufweisen.

13. Schichtmaterial gemäss Anspruch 1, dadurch gekennzeichnet, dass die Poren durch eine dünne geschlossene Barriereschicht aus dem Metalloxid von der Metallschicht getrennt sind.

14. Verfahren zur Herstellung eines Schichtmaterials gemäss Anspruch 1, dadurch gekennzeichent, dass man einem Träger, der mit einer Schicht eines anodisch oxidierbaren Metalls beschichtet ist, wobei deren Schichtdicke mindestens 5 nm entspricht, in einem Elektrolyten bei einer Spannung von 0,5 bis 100 V anodisch oxidiert, und die Oxidation beendet, bevor die Metallschicht vollständig durchoxidiert ist.

15. Verwendung eines Schichtmaterials gemäss Anspruch 1 als optisches Informationsaufzeichnungsmaterial.

## Claims

1. A layer material comprising a substrate on which is an electrically conductive metal layer which is covered with a porous metal oxide layer, wherein a thin, transparent and electrically conductive metal layer of an anodically oxidisable metal is applied on at least one surface of the substrate, the metal layer being covered by a thin transparent oxide layer of the said metal, and in which the oxide layer contains, distributed over the surface, fine pores which are closed towards the metal layer.

2. A layer material according to claim 1, wherein the substrate consists of a glass, a mineral, a ceramic, silicon or a plastic.

3. A layer material according to claim 2, wherein the substrate consists of glass or a transparent mineral or plastic.

4. A layer material according to claim 1, wherein the metal layer is formed from a valve metal.

5. A layer material according to claim 4, wherein the metal layer is formed from aluminium.

6. A layer material according to claim 1, wherein the metal layer has a thickness of 1.0 nm to 50 nm.

7. A layer material according to claim 6, wherein the thickness is 1.0 to 10 nm.

8. A layer material according to claim 7, wherein the thickness is 1.0 nm to 5 nm.

9. A layer material according to claim 1, wherein the oxide layer has a thickness of 10 nm to 50 µm.

10. A layer material according to claim 9, wherein the thickness is 10 nm to 10 µm.

11. A layer material according to claim 10, wherein the thickness is 10 nm to 100 nm.

12. A layer material according to claim 1, wherein the pores have a diameter of 2 nm to 500 nm.

13. A layer material according to claim 1, wherein the pores are separated from the metal layer by a thin closed barrier layer of the metal oxide.

14. A process for the production of a layer material according to claim 1, which comprises anodically oxidising a substrate coated with a layer of an anodically oxidisable metal, the layer having a thickness of at least 5 nm, in an electrolyte at a voltage of 0.5 to 100 V, and discontinuing oxidation before the metal layer has become completely oxidised.

15. Use of a layer material according to claim 1 as an optical information-recording material.

## Revendications

1. Matériau en couches formé d'un support portant une couche de métal électroconductrice recouverte d'une couche d'oxyde de métal poreuse, matériau caractérisé en ce que sur au moins une surface du support est appliquée une mince couche de métal, transparente et électroconductrice, d'un métal oxydable en anode, elle-même recouverte d'une couche d'oxyde de ce métal, mince et transparente, et dont la couche d'oxyde contient de fins pores répartis en surface, fermés à la couche de métal.

2. Matériau en couches selon la revendication 1, caractérisé en ce que le support est constitué par un verre, un minéral, une céramique, du silicium ou une matière plastique.

3. Matériau en couches selon la revendication 2, caractérisé en ce que le support est constitué de verre ou bien d'un minéral ou d'une matière plastique transparents.

4. Matériau en couches selon la revendication 1, caractérisé en ce que la couche de métal est formée d'un métal de soupape.

5. Matériau en couches selon la revendication 4, caractérisé en ce que la couche de métal est une couche d'aluminium.

6. Matériau en couches selon la revendication 1, caractérisé en ce que la couche de métal a une épaisseur de 1,0 à 50 nm.

7. Matériau en couches selon la revendication 6, caractérisé en ce que l'épaisseur de la couche de métal est de 1,0 à 10 nm.

8. Matériau en couches selon la revendication 7, caractérisé en ce que l'épaisseur est de 1,0 à 5 nm.

9. Matériau en couches selon la revendication 1, caractérisé en ce que la couche d'oxyde a une épaisseur de 10 nm à 50 µm.

10. Matériau en couches selon la revendication 9, caractérisé en ce que l'épaisseur de la couche d'oxyde est de 10 nm à 10 µm.

11. Matériau en couches selon la revendication 10, caractérisé en ce que l'épaisseur est de 10 à 100 nm.

12. Matériau en couches selon la revendication 1, caractérisé en ce que les pores ont un diamètre de 2 à 500 nm.

13. Matériau en couches selon la revendication 1, caractérisé en ce que les pores sont séparés de la couche d'oxyde de métal par une mince couche fermée de l'oxyde de métal, formant barrière.

14. Procédé de fabrication d'un matériau en couches selon la revendication 1, procédé caractérisé en ce que l'on soumet à une oxydation anodique un support recouvert d'une couche d'un métal oxydable en anode, couche dont l'épaisseur est d'au moins 5 nm, dans un électrolyte, à une tension de 0,5 à 100 V, en arrêtant l'oxydation avant que la couche de métal soit totalement oxydée en profondeur.

15. Emploi d'un matériau en couches selon la revendication 1 comme élément d'enregistrement optique d'informations.
